(19) Europäisches Patentamt / European Patent Office / Office européen des brevets

(11) **EP 4 439 093 A1**

(12) **EUROPEAN PATENT APPLICATION**

(43) Date of publication:
**02.10.2024 Bulletin 2024/40**

(21) Application number: **24163725.5**

(22) Date of filing: **15.03.2024**

(51) International Patent Classification (IPC):
**G01R 27/02** (2006.01)  **G01R 27/20** (2006.01)
**G01R 31/52** (2020.01)

(52) Cooperative Patent Classification (CPC):
**G01R 27/20; G01R 27/025; G01R 31/52**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **30.03.2023  GB 202304711**

(71) Applicant: **Rolls-Royce Deutschland Ltd & Co KG
15827 Blankenfelde-Mahlow (DE)**

(72) Inventors:
• **BÈRCES, Máté
15827 Blankenfelde-Mahlow (DE)**
• **BLEUER, Csaba
15827 Blankenfelde-Mahlow (DE)**

(54) **A FAULT MONITORING DEVICE FOR A POWER SYSTEM**

(57) A fault monitoring device for a power system that comprises a first parallel circuit (21, 22) of resistors, the first parallel circuit comprising a first branch (21) and a second branch (22) both connected at one end thereof to the high side voltage rail (3) of the power system, and a second parallel circuit (23, 24) of resistors, the second parallel circuit comprising a third branch (23) and a fourth branch (24) both connected at one end thereof to the low side voltage rail (4) of the power system. The branches (21, 22, 23, 24) are each connected at the other end thereof to the chassis (5) of the power system. The second branch (22) comprises at least two electrical resistors (R_INJ_1, R_INJ_2, R_INJ_3) arranged in series, wherein at least one of the electrical resistors (R_INJ_2, R_INJ_3) can be short-circuited by a first switch (SW1, SW3). The fourth branch (24) comprises at least two electrical resistors (R_INJ_4, R_INJ_5, R_INJ_6) arranged in series, wherein at least one of the electrical resistors (R_INJ_4, R_INJ_5) can be short-circuited by a second switch (SW2, SW4). A controller (6) is configured to selectively switch the switches (SW1, SW2, SW3, SW4) to provide for different states of the first and second parallel circuits (21, 22; 23, 24), and determine from voltage changes associated with the different states the resistance values for the high side insulation resistance ($R_{ISOH}$) and for the low side insulation resistance ($R_{ISOL}$) of the power system.

Fig. 1

EP 4 439 093 A1

**Description**

**FIELD OF THE DISCLOSURE**

The present disclosure relates to a fault monitoring device for a power system and a method for estimating the end voltage reached at the end of charging a capacitance.

**BACKGROUND**

United States patent applications US 2022/0413034 A1 and US 2022/0413035 A1 disclose an insulation monitoring device comprising a primary resistance circuit and a secondary resistance circuit arranged in parallel to a high side insulation resistance and a low side insulation resistance, wherein the secondary resistance circuit comprises additional resistors which are selectively connectable to a high voltage bus via a switching circuit. Four different states can be implemented by the switches. Voltage values associated with the different states are used to calculate the resistance values for the high side insulation resistance and the low side insulation resistance. The underlying idea lies in the injection of a common mode voltage on the high-voltage bus by connecting additional resistors of the secondary resistance circuit to the high voltage bus.

With such prior art insulation monitoring devices, an important design aspect is the maximum common mode voltage impressed onto the high voltage bus. A drawback lies in that the resistance of the additional resistors typically needs to be large in value (such as larger than 50 MΩ) in view of the fact that the high side insulation resistance and the low side insulation resistance are typically high in value. Otherwise, no substantial common mode voltage can be injected to the high-voltage bus. However, implementing the additional resistors with a high resistance can be difficult in view of potential contaminations during manufacturing and operation.

Another drawback lies in that in case there is an insulation fault with the high side insulation resistance or the low side insulation resistance, the common mode voltage is very small and the measurement accuracy is thus decreased.

A still further drawback lies in that long response times are required when measuring high side insulation resistances and low side insulation resistances with high resistance values due to the fact that RC circuits with capacitive loads are present in the system, wherein such RC circuits may have large RC time constants.

The present invention provides an insulation monitoring device and a method that addresses the above-mentioned drawbacks or at least provides a useful alternative to known insulation monitoring devices and methods.

**SUMMARY**

According to a first aspect of the invention, a fault monitoring device for a power system is provided. The power system for which the fault monitoring device is provided for is of the kind that comprises a high side voltage rail, a low side voltage rail, and a chassis insulated by a high side insulation resistance from the high side voltage rail and insulated by a low side insulation resistance from the low side voltage rail. The high side voltage rail and the low side voltage rail form part of a high voltage bus connected to a DC battery.

The fault monitoring device comprises a first parallel circuit of resistors and a second parallel circuit of resistors. The first parallel circuit of resistors comprises a first branch and a second branch both connected at one end thereof to the high side voltage rail of the power system. The second parallel circuit of resistors comprises a third branch and a fourth branch both connected at one end thereof to the low side voltage rail of the power system. It is further provided that the first branch, second branch, third branch and fourth branch are each connected at the other end thereof to the chassis of the power system. The second branch of the first parallel circuit comprises at least two electrical resistors arranged in series, wherein at least one of the electrical resistors can be short-circuited by a first switch. The fourth branch of the second parallel circuit also comprises at least two electrical resistors arranged in series, wherein at least one of the electrical resistors can be short-circuited by a second switch.

The fault monitoring device further comprises a controller configured to selectively switch the switches of the second branch and of the fourth branch to provide for different states of the first and second parallel circuits. The controller is further configured to determine from voltage changes associated with the different states the resistance values for the high side insulation resistance and for the low side insulation resistance of the power system.

Aspects of the invention are thus based on the idea of providing parallel resistor networks both on the high side and on the low side of a power system, wherein one of the branches of each resistor network comprises resistors which can be short-circuited by means of switches, thereby allowing injection of a common mode voltage on the high-voltage bus. By using switches to short-circuit resistors, more current is allowed to flow compared to circuits as disclosed in US 2022/0413034 A1 and US 2022/0413035 A1, thereby increasing the impressed common mode voltage. At the same time, the maximum resistance of the branch with the resistors that can be short-circuited can be limited. Limitations in the common mode voltage impressed onto the high voltage bus and regarding the maximum resistance in the parallel resistor networks can thus be avoided.

According to an embodiment, the second branch of the first parallel circuit comprises three electrical resistors arranged in series, wherein two of the electrical resistors can be short-circuited by the first switch and a third switch, respectively. In the same manner, the fourth branch of the second parallel circuit comprises three electrical resistors arranged in series, wherein two of the electrical resistors can be short-circuited by the second switch and a fourth switch, respectively. By the provision of several switches a plurality of states can be realized, allowing additional options and granularity in the injection of a common mode voltage. Further, different measurement ranges can be defined. In an embodiment, a high measurement range is defined in case the quotient of the product to the sum of the high side insulation resistance and the low side insulation resistance is large in value, such as larger than a particular resistance value dependent on system parameters such as 2MΩ. A low measurement range is defined in case the quotient of the product to the sum of the high side insulation resistance and the low side insulation resistance is small in value, such as smaller than a particular resistance value dependent on system parameters such as 2MΩ. Different switches are switched depending on relevant measurement range.

In a further embodiment, the controller is configured to define two different states by the selective switching, wherein the controller determines from the voltage changes associated with the two different states the resistance values for the high side insulation resistance and the low side insulation resistance. Accordingly, two different states only need to be defined by means of the selective switching. Based on the corresponding voltage changes (and the corresponding common mode voltage injection on the high-voltage bus), the high side insulation resistance and the low side insulation resistance are determined.

To this end, in an embodiment, the controller is configured to determine from the voltage changes associated with the two different states the resistance values for the high side insulation resistance and the low side insulation resistance in that it is configured to:

measure the high side voltage between the high side voltage rail and the chassis,
measure the low side voltage between the chassis and the low side voltage rail,
measure the high side voltage and the low side voltage in the two different states,
use the high side voltages of the two different states, the low side voltages of the two different states, and the change of resistance of the sum of the resistors of the second branch and/or of the sum of the resistors of the fourth branch between the two different states to calculate the high side insulation resistance and the low side insulation resistance. The calculation is in accordance with Ohm's law and the well-known formulae about the total resistance in a series circuit and a parallel circuit of resistances.

In this respect, a first state may be defined in that one of the electrical resistors of the second branch is short-circuited while none of the electrical resistors of the fourth branch is short-circuited, and in that the second state is defined in that none of the electrical resistors of the second branch is short-circuited while one of the electrical resistors of the fourth branch is short-circuited. The corresponding bias leads to the injection of a common mode voltage.

More particularly, in case two switches both in the second branch and in the fourth branch are present, in the first state one of the electrical resistors of the second branch may be short-circuited by the first switch, and in the second state one of the electrical resistors of the fourth branch may be short-circuited by the second switch. Such a configuration may be used in the above-mentioned high measurement range.

Alternatively, in the first state one of the electrical resistors of the second branch may be short-circuited by the third switch, and in the second state one of the electrical resistors of the fourth branch may be short-circuited by the fourth switch. Such a configuration may be used in the above-mentioned low measurement range.

In a specific embodiment, the high side insulation resistance $R_{ISOH}$ and the low side insulation resistance $R_{ISOL}$ are calculated by the formulae

$$R_{ISO_H} = \frac{\dfrac{U_{HIGH_1}}{U_{LOW_1}} - \dfrac{U_{HIGH_2}}{U_{LOW_2}}}{-\dfrac{U_{HIGH_1}}{U_{LOW_1}}\dfrac{1}{R_{MEAS}} - \dfrac{U_{HIGH_1}}{U_{LOW_1}}\dfrac{1}{R_{INJ_{ON}}} + \dfrac{U_{HIGH_2}}{U_{LOW_2}}\dfrac{1}{R_{MEAS}} + \dfrac{U_{HIGH_2}}{U_{LOW_2}}\dfrac{1}{R_{INJ_{OFF}}} + \dfrac{1}{R_{INJ_{OFF}}} - \dfrac{1}{R_{INJ_{ON}}}}$$

$$R_{ISO_L} =$$

$$= \frac{\dfrac{U_{HIGH_1}}{U_{LOW_1}} - \dfrac{U_{HIGH_2}}{U_{LOW_2}}}{\dfrac{U_{HIGH_1}}{U_{LOW_1}}\dfrac{U_{HIGH_2}}{U_{LOW_2}}\dfrac{1}{R_{INJ_{OFF}}} - \dfrac{U_{HIGH_1}}{U_{LOW_1}}\dfrac{U_{HIGH_2}}{U_{LOW_2}}\dfrac{1}{R_{INJ_{ON}}} - \dfrac{U_{HIGH_1}}{U_{LOW_1}}\dfrac{1}{R_{MEAS}} - \dfrac{U_{HIGH_1}}{U_{LOW_1}}\dfrac{1}{R_{INJ_{ON}}} + \dfrac{U_{HIGH_2}}{U_{LOW_2}}\dfrac{1}{R_{MEAS}} + \dfrac{U_{HIGH_2}}{U_{LOW_2}}\dfrac{1}{R_{INJ_{OFF}}}}$$

wherein:

- $R_{ISOH}$ is the high side insulation resistance,
- $R_{ISOL}$ is the low side insulation resistance,
- $U_{HIGH1}$ is high side voltage between the high side voltage rail and the chassis in the first state,
- $U_{HIGH2}$ is the high side voltage between the high side voltage rail and the chassis in the second state,
- $U_{LOW1}$ is the low side voltage between the chassis and the low side voltage rail in the first state,
- $U_{LOW2}$ is the low side voltage between the chassis and the low side voltage rail in the second state,
- $R_{MEAS}$ is the resistance of the first branch and the resistance of the third branch (assuming these are identical),
- $R_{INJON}$ is the resistance of the sum of the resistors of the second branch and the sum of the resistors of the fourth branch if one of the resistors of the respective branch is short-circuited (assuming these are identical for the second branch and for the fourth branch),
- $R_{INJOFF}$ is the resistance of the sum of the resistors of the second branch and the sum of the resistors of the fourth branch if none of the resistors are short-circuited (assuming these are identical for the second branch and for the fourth branch).

In an embodiment, the first branch comprises a first voltage divider, wherein the fault monitoring device is configured to measure the high side voltage between the high side voltage rail and the chassis by means of the first voltage divider. Further, the third branch comprises a second voltage divider, wherein the fault monitoring device is configured to measure the low side voltage between the low side voltage rail and the chassis by means of the second voltage divider. The use of a voltage divider represents a simple but effective means for measuring the high side voltage and the low side voltage.

The voltage changes associated with the different states settle with an exponential curve due to capacitances that are connected in parallel to the high side insulation resistance and the low side insulation resistance. Such capacitances represent the capacitance of the power system and may be formed, e.g., by cable insulations and filter capacitors. In an embodiment, the controller is configured to apply a regression analysis which estimates the voltage change before they are settled in. The provision of such regression analysis allows to reduce the time it takes to determine the high side insulation resistance and the low side insulation resistance. This time depends on the resistance and capacitance values of RC circuits present in the system. Such RC circuit may have large RC time constants of up to tens of seconds when a high capacitive load and a high resistance are present, wherein the time constant is equal to the product of R and C (R*C). Without a regression analysis, the time of several time constants (such as at least five) needs to be waited until the high side insulation resistance and the low side insulation resistance can be determined which means of the presence of a long response time. Using a regression analysis, the settled in value can be calculated without having to wait for the voltage settling in.

In an embodiment, the controller is configured to apply a regression analysis for the voltage of each of the capacitances:

measuring voltage values at the beginning only of an exponential charging curve charging the capacitance,
calculating the derivatives of the measured voltage values and subsequently a logarithm of the derivatives,
fitting a line through the calculated values using a linear regression method, the line being defined by parameters,
using the initial voltage value of the capacitance and the line parameters to calculate the end voltage.

In a further aspect of the invention, the present invention regards a power system that comprises:

a DC battery having a DC battery positive terminal, a DC battery negative terminal and a battery voltage,
a high side voltage rail connected to the DC battery positive terminal,
a low side voltage rail connected to the DC battery negative terminal, a chassis,
a high side insulation resistance insulating the chassis from the high side voltage rail,
a low side insulation resistance insulating the chassis from the low side voltage rail, and
a fault monitoring device of the first aspect.

In a still further aspect of the invention, the present invention provides for a method for estimating the end voltage reached at the end of charging a capacitance, the method comprising:

measuring voltage values at the beginning only of an exponential charging curve charging the capacitance,
calculating the derivatives of the measured voltage values and subsequently a logarithm of the derivatives,
fitting a line through the calculated values using a linear regression method, the line being defined by parameters,
using the initial voltage value of the capacitance and the line parameters to calculate the end voltage.

This aspect of the invention is based on measuring voltage values at the beginning of an exponential charging curve only to reduce response time. A logarithm (such as the natural logarithm) of a derivative of these values is calculated and a line is fit through these calculated values. The line has defined parameters (such as slope and y-intercept). The idea underlying this aspect of the invention lies in that the parameters of this line are measured and used to calculate the end voltage. Using such regression analysis, the settled in value, i.e., the end voltage reached at the end of charging the capacitance, can be calculated more quickly without having to wait for the voltage to settle in.

According to an embodiment, the line comprises as parameters a slope m and a y-intercept b, wherein the using step comprises using the initial voltage value of the capacitance, the slope m and the y-intercept b to calculate the determining the end voltage. The parameters m and b can be easily determined from the line.

In this respect, it may be provided, when $\tau$ is the time constant of the RC system, the voltage values of the exponential charging curve are measured up to at most $\tau$, in particular up to at most $\tau/2$. The response time after switching to a different state is reduced accordingly.

The skilled person will appreciate that except where mutually exclusive, a feature or parameter described in relation to any one of the above aspects may be applied to any other aspect. Furthermore, except where mutually exclusive, any feature or parameter described herein may be applied to any aspect and/or combined with any other feature or parameter described herein.

**BRIEF DESCRIPTION OF THE DRAWINGS**

The invention will be explained in more detail on the basis of exemplary embodiments with reference to the accompanying drawings in which:

FIG. 1 is an embodiment of a fault monitoring device for a power system in accordance with the present invention;
FIG. 2 is a capacitor charging voltage dependent on time;
FIG. 3 is a line fitted through the logarithm of the derivative of voltage values measured at the beginning of a capacitor charging; and
FIG. 4 is a flow chart of a method for estimating the end voltage reached at the end of charging a capacitance.

**DETAILED DESCRIPTION**

Aspects and embodiments of the present disclosure will now be discussed with reference to the accompanying figures. Further aspects and embodiments will be apparent to those skilled in the art.

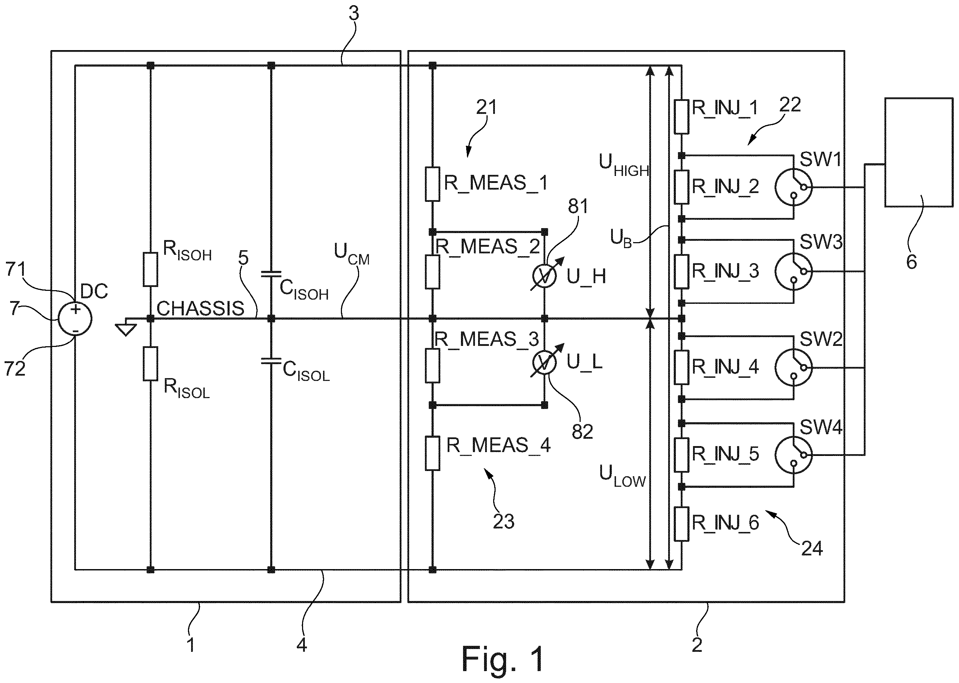

FIG. 1 shows an embodiment of a fault monitoring device 2. The fault monitoring device 2 is configured to measure a high side insulation resistance $R_{ISOH}$ and a low side insulation resistance $R_{ISOL}$ of a power system 1.

The power system 1 is shown on the left-hand side of FIG. 1. It comprises a DC battery 7 that has a positive terminal 71 and a negative terminal 72. Between the positive terminal 71 and the negative terminal 72 a battery voltage $U_B$ is present. A high side voltage rail 3 is connected to the DC battery positive terminal 71 and a low side voltage rail 4 is connected to the DC battery negative terminal 72. The high side voltage rail 3 and the low side voltage rail 4 form a high-voltage bus.

The power system 1 further comprises a chassis 5. The chassis 5 is insulated from the high side voltage rail 3 by the high side insulation resistance $R_{ISOH}$. Further, the chassis 5 is insulated from the low side voltage rail 4 by the low side insulation resistance $R_{ISOL}$.

The voltage between the high side voltage rail 3 and the chassis 5 is the high side voltage $U_{HIGH}$. The voltage between the chassis 5 and the low side voltage rail 4 is the low voltage $U_{LOW}$. The sum of the high voltage and the low voltage is equal to the battery voltage: $U_B = U_{HIGH} + U_{LOW}$. A common mode voltage $U_{CM}$ is present at the chassis 5, the common mode voltage being defined as the arithmetic mean of the high voltage and the low voltage: $U_{CM} = \frac{1}{2}(U_{HIGH} - U_{LOW})$. If the high voltage $U_{HIGH}$ and the low voltage $U_{LOW}$ are equal, the common mode voltage is zero.

In parallel to the high side insulation resistance $R_{ISOH}$ a capacitance $C_{ISOH}$ is arranged between the chassis 5 and the high side voltage rail 3. Similarly, in parallel to the low side insulation resistance $R_{ISOL}$ a capacitance $C_{ISOL}$ is arranged between the chassis 5 and the low side voltage rail 4. The capacitances $C_{ISOH}$ and $C_{ISOL}$ represent capacitive loads of the system.

In a power system such as the power system 1 of FIG. 1, it is required that the insulation of the high side voltage rail 3 and of the low side voltage rail 4 from the chassis 5 is monitored. This can be done by monitoring the values of the resistances $R_{ISOH}$ and $R_{ISOL}$. The fault monitoring device 2 of FIG. 1 serves to provide for such monitoring.

The fault monitoring device 2 comprises a first parallel circuit of resistors, the first parallel circuit comprising a first branch 21 and a second branch 23 which are both connected at one end thereof to the high side voltage rail 3 of the power system 1. The first branch 21 comprises a first resistor M_MEAS_1 and a second resistor M_MEAS_2 which are arranged in series and form a first voltage divider. The resistance of the first resistor M_MEAS_1 is substantially larger than the resistance of the second resistor M_MEAS_2. For example, the first resistor M_MEAS_1 may have a resistance in the range between 10 MΩ and 50 MΩ, while the second resistor M_MEAS_2 may have a resistance in the range between 10 and 100 kΩ.

A voltage U_H is measured by a first voltage meter 81 between a point between the first and second resistors M_MEAS_1, M_MEAS_2 and the chassis 5. By measuring the voltage U_H, the high voltage $U_{HIGH}$ can be calculated using the formula:

$$U_{HIGH} = \frac{R\_MEAS\_1 + R\_MEAS\_2}{R\_MEAS\_2} U\_H$$

The second branch 22 of the first parallel circuit comprises three electrical resistors R_INJ_1, R_INJ_2, R_INJ_3 arranged in series, wherein two of the electrical resistors R_INJ_2, R_INJ_3 can be short-circuited by a first switch SW1 and a third switch SW3.

The fault monitoring device 2 further comprises a second parallel circuit of resistors, the second parallel circuit comprising a third branch 23 and a fourth branch 24 which are both connected at one end thereof to the low side voltage rail 4 of the power system 1. The third branch 21 comprises a third resistor M_MEAS_3 and a fourth resistor M_MEAS 4 which are arranged in series and form a second voltage divider. The resistance of the fourth resistor M_MEAS 4 is substantially larger than the resistance of the third resistor M_MEAS_3. For example, the fourth resistor M_MEAS 4 may have a resistance in the range between 10 MΩ and 50 MΩ, while the third resistor M_MEAS_3 may have a resistance in the range between 10 and 100 kΩ.

A voltage U_L is measured by a second voltage meter 82 between a point between the third and fourth resistors M_MEAS_3, M_MEAS_4 and the chassis 5. By measuring the voltage U_L, the low voltage $U_{LOW}$ can be calculated using the formula:

$$U_{LOW} = \frac{R\_MEAS\_3 + R\_MEAS\_4}{R\_MEAS\_3} U\_L$$

The voltage dividers of branches 21, 23 thus serve to measure the high voltage $U_{HIGH}$ and the low voltage $U_{LOW}$. Other embodiments may use other methods to get or measure or determine U_HIGH and U_LOW.

The fourth branch 24 of the second parallel circuit comprises three electrical resistors R_INJ_4, R_INJ_5, R_INJ_6 arranged in series, wherein two of the electrical resistors R_INJ_4, R_INJ_5 can be short-circuited by a second switch SW2 and a fourth switch SW4.

The first branch 21, the second branch 22, the third branch 23 and the fourth branch 24 are each connected at the other end thereof to the chassis 5 of the power system 1.

When applying the fault monitoring device 2 to the power system 1, the first parallel circuit 21, 22 with branches 21, 22 is connected in parallel to the high side insulation resistance $R_{ISOH}$ and the second parallel circuit 23, 24 with branches 23, 24 is connected in parallel to the low side insulation resistance $R_{ISOL}$. By switching the switches SW1 to SW4 a common mode voltage $V_{CM}$ different from zero can be injected.

The fault monitoring device 2 further comprises a controller 6 schematically depicted in FIG. 1. The controller 6 may be implemented in software and/or hardware. For example, the controller 6 may comprise software stored in a memory and executed by a processor. The controller 6 is operatively coupled to the switches SW1, SW2, SW3, SW4 and configured to selectively switch the switches SW1, SW2, SW3, SW4 of the second branch 22 and of the fourth branch 24, thereby providing for different states of the first and second parallel circuits 21, 22, 23, 24. The controller 6 is further configured to determine from voltage changes associated with the different states the resistance values for the high side insulation resistance $R_{ISOH}$ and for the low side insulation resistance $R_{ISOL}$ of the power system 1. In this respect, the controller 6 may control and/or read values of other elements of the fault monitoring device 2 as well such as of voltage meters 81, 82 measuring the voltages U_H, U_L.

Accordingly, by selectively switching different of the switches SW1, SW2, SW3, SW4, voltage changes can be induced which lead to a different common mode voltages which are impressed on the high-voltage bus, wherein the different voltages are associated with different states, and wherein the different states are defined by the selective switching of the switches SW1, SW2, SW3, SW4.

This will in the following be discussed in an embodiment, wherein two states that corresponds with two different selective switchings are considered and evaluated to determine the value of the resistances $R_{ISOH}$ and $R_{ISOL}$. In other embodiments, however, other of the switches SW1, SW2, SW3, SW4 may be selected, achieving a similar result. Also, it may be provided for in alternative embodiments that only one switch or more than two switches are arranged in branches 22, 24. Accordingly, the following embodiment is to be understood as an example only.

With the embodiment of FIG. 1 having two switches in each branch 22, 24, two measurement ranges can be implemented alternatively. The two measurement ranges are applied depending on the value of the resistances $R_{ISOH}$ and $R_{ISOL}$. More particularly, a high measurement range is defined when

$$(R_{ISOH} * R_{ISOL}) / (R_{ISOH} + R_{ISOL})$$

is large in value, such as larger than a particular resistance value dependent on system parameters such as 2MΩ.
A low measurement range is defined when

$$(R_{ISOH} * R_{ISOL}) / (R_{ISOH} + R_{ISOL})$$

is small in value, such as smaller than a particular resistance value dependent on system parameters such as 2MΩ.
In the high measurement range, switches SW1 and SW2 are used. In the low measurement range, switches SW3 and SW4 are used.
Two states, state 1 and state 2, of the resistors circuits (and thus the fault monitoring device) are defined as follows:

> In state 1, one of the switches SW1, SW3 on the high side branch 22 is closed (meaning SW1 or SW3 is ON and the respective resistor R_INJ_2, R_INJ_3 is short-circuited), while on the low side branch 24 every switch is open (SW2 and SW4 are OFF, meaning none of the resistors R_INJ_4, R_INJ_5) are short-circuited). Switch SW1 is ON in the high measurement range. Switch SW3 is ON in the low measurement range.
> In state 2 one the switches SW2, SW4 on the low side branch 24 is closed (meaning SW2 or SW4 is ON and the respective resistor R_INJ_4, R_INJ_5 is short-circuited), while on the high side branch 22 every switch is open (SW1 and SW3 are OFF, meaning none of the resistors R_INJ_2, R_INJ_3 are short-circuited). Switch SW2 is ON in the high measurement range. Switch SW4 is ON in the low measurement range.

Further, the following assumptions are made and abbreviations are introduced, such that the subsequent equations become simpler.

$$R_{MEAS} = R\_MEAS\_1 + R\_MEAS\_2 = R\_MEAS\_3 + R\_MEAS\_4$$

$$R_{INJ_{OFF}} = R\_INJ\_1 + R\_INJ\_2 + R\_INJ\_3 = R\_INJ\_4 + R\_INJ\_5 + R\_INJ\_6$$

For the high measurement range:

$$R_{INJ_{ON}} = R\_INJ\_1 + R\_INJ\_3 = R\_INJ\_5 + R\_INJ\_6$$

For the low measurement range:

$$R_{INJ_{ON}} = R\_INJ\_1 + R\_INJ\_2 = R\_INJ\_4 + R\_INJ\_6$$

$U_{HIGH_1}$: $U_{HIGH}$ measured in state 1
$U_{HIGH_2}$: $U_{HIGH}$ measured in state 2
$U_{LOW_1}$: $U_{LOW}$ measured in state 1
$U_{LOW_2}$: $U_{LOW}$ measured in state 2

Accordingly, it is assumed that the high-voltage side and the low-voltage side are symmetrical. These assumptions are not necessary though, and the skilled person will appreciate that they are not required. For example, every resistor can be different.
Further, the total resistance $R_H$ is defined as the total resistance between the chassis 5 and the high side voltage rail 3. It is to be noted that the total resistance $R_H$ depends on the resistance $R_{ISOH}$ of the power system 1 and of the resistances of the branches 21, 22 of the fault monitoring device 2, wherein in accordance with the laws on parallel resistors the total resistance $R_H$ of all branches is the reciprocal of the sum of the reciprocals of the resistances of each branch (with the resistance $R_{ISOH}$ also representing one branch).

$R_{H1}$ is the total resistance $R_H$ in the first state and $R_{H2}$ is the total resistance $R_H$ in the second state.

Further, the total resistance $R_L$ is defined as the total resistance between the chassis 5 and the low side voltage rail 4. It is to be noted that the total resistance $R_L$ depends on the resistance $R_{ISOL}$ of the power system 1 and of the resistances of the branches 23, 24 of the fault monitoring device 2, wherein in accordance with the laws on parallel resistors the total resistance $R_L$ of all branches is the reciprocal of the sum of the reciprocals of the resistances of each branch (with the resistance $R_{ISOL}$ also representing one branch).

$R_{L1}$ is the total resistance $R_L$ in the first state and $R_{L2}$ is the total resistance $R_L$ in the second state.

Based on the above definitions and values, the following is true under Ohm's law:

$$\frac{R_H}{R_L} = \frac{U_{HIGH}}{U_{LOW}}$$

In state 1, there is a parallel connection of resistances on the high side and low side as follows:

$$\frac{U_{HIGH_1}}{U_{LOW_1}} = \frac{R_{H_1}}{R_{L_1}} = \frac{\dfrac{1}{\frac{1}{R_{ISO_H}} + \frac{1}{R_{MEAS}} + \frac{1}{R_{INJ_{ON}}}}}{\dfrac{1}{\frac{1}{R_{ISO_L}} + \frac{1}{R_{MEAS}} + \frac{1}{R_{INJ_{OFF}}}}} = \frac{\frac{1}{R_{ISO_L}} + \frac{1}{R_{MEAS}} + \frac{1}{R_{INJ_{OFF}}}}{\frac{1}{R_{ISO_H}} + \frac{1}{R_{MEAS}} + \frac{1}{R_{INJ_{ON}}}}$$

In state 2, there is a parallel connection of resistances on the high side and low side as follows:

$$\frac{U_{HIGH_2}}{U_{LOW_2}} = \frac{R_{H_2}}{R_{L_2}} = \frac{\dfrac{1}{\frac{1}{R_{ISO_H}} + \frac{1}{R_{MEAS}} + \frac{1}{R_{INJ_{OFF}}}}}{\dfrac{1}{\frac{1}{R_{ISO_L}} + \frac{1}{R_{MEAS}} + \frac{1}{R_{INJ_{ON}}}}} = \frac{\frac{1}{R_{ISO_L}} + \frac{1}{R_{MEAS}} + \frac{1}{R_{INJ_{ON}}}}{\frac{1}{R_{ISO_H}} + \frac{1}{R_{MEAS}} + \frac{1}{R_{INJ_{OFF}}}}$$

The only two unknowns in these equations are $R_{ISO_H}$ and $R_{ISO_L}$. These can be expressed as follows:

$R_{ISO_H}$

$$= \frac{\dfrac{U_{HIGH_1}}{U_{LOW_1}} - \dfrac{U_{HIGH_2}}{U_{LOW_2}}}{-\dfrac{U_{HIGH_1}}{U_{LOW_1}}\dfrac{1}{R_{MEAS}} - \dfrac{U_{HIGH_1}}{U_{LOW_1}}\dfrac{1}{R_{INJ_{ON}}} + \dfrac{U_{HIGH_2}}{U_{LOW_2}}\dfrac{1}{R_{MEAS}} + \dfrac{U_{HIGH_2}}{U_{LOW_2}}\dfrac{1}{R_{INJ_{OFF}}} + \dfrac{1}{R_{INJ_{OFF}}} - \dfrac{1}{R_{INJ_{ON}}}}$$

$R_{ISO_L} =$

$$= \frac{\dfrac{U_{HIGH_1}}{U_{LOW_1}} - \dfrac{U_{HIGH_2}}{U_{LOW_2}}}{\dfrac{U_{HIGH_1}}{U_{LOW_1}}\dfrac{U_{HIGH_2}}{U_{LOW_2}}\dfrac{1}{R_{INJ_{OFF}}} - \dfrac{U_{HIGH_1}}{U_{LOW_1}}\dfrac{U_{HIGH_2}}{U_{LOW_2}}\dfrac{1}{R_{INJ_{ON}}} - \dfrac{U_{HIGH_1}}{U_{LOW_1}}\dfrac{1}{R_{MEAS}} - \dfrac{U_{HIGH_1}}{U_{LOW_1}}\dfrac{1}{R_{INJ_{ON}}} + \dfrac{U_{HIGH_2}}{U_{LOW_2}}\dfrac{1}{R_{MEAS}} + \dfrac{U_{HIGH_2}}{U_{LOW_2}}\dfrac{1}{R_{INJ_{OFF}}}}$$

Accordingly, $R_{ISOH}$ and $R_{ISOL}$ can be monitored by the fault monitoring device 2 by introducing different states by the switches SW1, SW2, SW3, SW4, by measuring the above stated voltage and resistance values, by carrying out the above calculations for $R_{ISOH}$ and $R_{ISOL}$. Different states may be defined for a high measurement range and for low measurement range.

The measurements and calculations may be carried out by the controller 6 or an entity connected to controller 6 (which also would be a controlling entity).

As already pointed out, this calculation is to be understood as an example only. In other embodiments, different switching of switches SW1, SW2, SW3, SW4 may be implemented. For example, alternatively, switches SW1 and SW3 may be switched together and switches SW2 and SW4 may be switched together to achieve additional measurement ranges. Further, the above stated assumptions are not required. For example, all resistors may have different values. The above formulae then turn more complex but are still based on well-known principles about the total resistance in parallel circuits and series circuits.

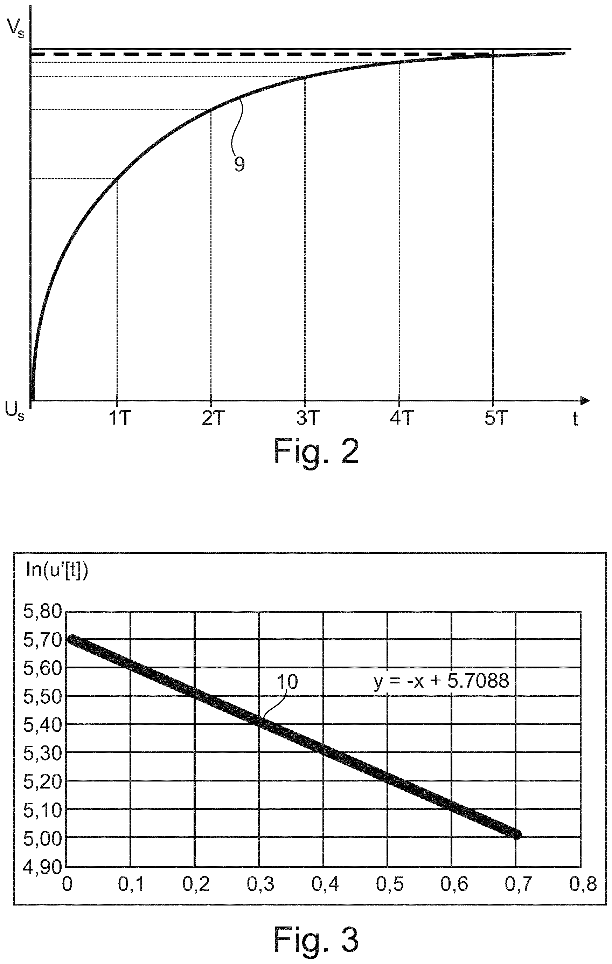

The described fault monitoring device 2 can be further improved by implementing a method for estimating the end voltage reached at the end of charging the capacitances C_ISO_H and C_ISO_H. A problem is based on the fact that, upon a voltage change caused by the selective switching, the capacitances C_ISO_H and C_ISO_H are charged. As is well known, in such case, the voltage settles with an exponential curve, the exponential curve having a time constant $\tau$ which depends on the product of resistance and capacitance. This is shown in **FIG. 2** which schematically depicts the well-known curve 9 for charging a capacitor, wherein the voltage is shown dependent on time, wherein the x-axis is divided in multiples of the time constant $\tau$. It can be assumed that after at least five times the time constant $\tau$ the voltage is settled in. When making the measurements discussed with respect to FIG. 1 after the voltage has settled in (to have the correct values of, e.g., $U_{HIGH}$ and $U_{LOW}$), a long response time of, e.g., up to 20-200 seconds, is present when a high capacitance and a high resistance are present on the high-voltage bus.

To avoid such a long response times, aspects of the present invention implement a regression analysis which estimates the changed voltages before they are settled in. In particular, and exponential regression calculation method is implemented.

The exponential regression calculation method is based on the following considerations.

The capacitor charging equation in an RC circuit with an initial $U_1$ voltage charged up to a $U_2$ voltage, and with a time constant $\tau$ reads:

$$U(t) = (U_1 - U_2) \cdot e^{-\frac{t}{\tau}} + U_2$$

$U_2$ is the end voltage of interest.

The derivative by time is:

$$U'(t) = \frac{dU(t)}{dt} = (U_1 - U_2) \cdot e^{-\frac{t}{\tau}} \cdot -\frac{1}{\tau} = (U_2 - U_1) \cdot e^{-\frac{t}{\tau}} \cdot \frac{1}{\tau}$$

Next, the natural logarithm of both sides is taken, this leading to a linear equation as follows:

$$\ln\big(U'(t)\big) = \ln\left((U_2 - U_1) \cdot e^{-\frac{t}{\tau}} \cdot \frac{1}{\tau}\right) = \ln\left((U_2 - U_1) \cdot \frac{1}{\tau}\right) + \ln\left(e^{-\frac{t}{\tau}}\right)$$

$$= \ln\left((U_2 - U_1) \cdot \frac{1}{\tau}\right) - \frac{t}{\tau}$$

This aspect of the invention is based on the realization that the above equation is similar to the well-known equation of a line:

$$f(t) = mt + b,$$

wherein m is the slope and b is the y-intercept.

Comparing the $\ln(U'(t))$ with $f(t)$ leads to:

$$m = -\frac{1}{\tau} \; ; \; b = \ln\left((U_2 - U_1) \cdot \frac{1}{\tau}\right)$$

The variable of interest is $U_2$. $U_1$ as the initial voltage is known. The parameters m and b can be calculated, $\tau$ is unknown. The above formula can be transformed to:

$$\tau = -\frac{1}{m} \; ; \; e^b = (U_2 - U_1) \cdot \frac{1}{\tau}$$

$$e^b = (U_2 - U_1) \cdot -m$$

$$U_2 = U_1 - \frac{e^b}{m}$$

What is still required is to determine the parameters m and b.

To this end, the measured voltage values at the beginning of the exponential charging curve 9 of FIG. 2 are measured and further analysed. It is only the voltage values at the beginning of the charging curve 9 that are measured and further analysed as, otherwise, the response time would not be reduced. For example, only the voltage values within the first time interval between 0 and $1\tau$ or the first half of that time interval ($\tau/2$) are considered.

The voltage values u(t) are measured at discrete time intervals: $u[t_n]$.

The derivative can be found by:

$$u'[t_n] = \frac{u[t_n] - u[t_{n-1}]}{t_n - t_{n-1}} \, .$$

The natural logarithm of $u'[t_n]$ is:

$$\ln(u'[t_n]) = \ln\left(\frac{u[t_n] - u[t_{n-1}]}{t_n - t_{n-1}}\right)$$

The natural logarithm leads to a sequence of discrete points approximately forming a line. For these points a simple linear regression can be implemented to get the m and b values. This is illustrated in **FIG. 3**, which shows ln $(u'[t_n])$ dependent on time, wherein the time resolution is 0.1 seconds. After linear regression, a line 10 is present and the m and b values can thus be taken from the determined line 10. In the embodiment shown in FIG. 3, m is equal to -1 and b is equal to 5.7088.

This allows to determine a $U_2$ according to the formula:

$$U_2 = U_1 - \frac{e^b}{m}$$

The regression calculation thus allows to determine the end voltage $U_2$ in much less time compared an exponential setting of the voltage.

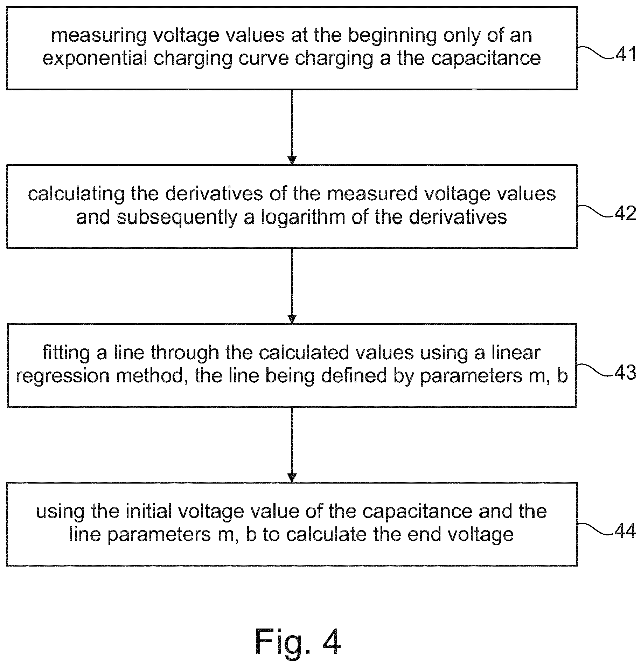

**FIG. 4** summarizes the main steps of the method. In step 41, the voltage values at the beginning of an exponential charging curve charging a capacitance are measured, such as the voltage values within a time interval of $\tau$ or $\tau/2$. In step 42, the derivatives of the measured voltage values are calculated and subsequently a logarithm of the derivatives is taken. This leads to a sequence of values which is arranged approximately as a line. In step 42, a line is fitted through the calculated values using a linear regression method. The fitted line naturally is defined by parameters such as parameters m, b (other representations of a line may use different parameters). Finally, in step 44, the initial voltage value of the capacitance and the line parameters m, b are used to calculate the end voltage $U_2$, e.g., in accordance with the above formula.

It should be understood that the above description is intended for illustrative purposes only, and is not intended to limit the scope of the present disclosure in any way. Also, those skilled in the art will appreciate that other aspects of the disclosure can be obtained from a study of the drawings, the disclosure and the appended claims. All methods described herein can be performed in any suitable order unless otherwise indicated herein or otherwise clearly contradicted by context. Various features of the various embodiments disclosed herein can be combined in different combinations to create new embodiments within the scope of the present disclosure. In particular, the disclosure extends to and includes all combinations and sub-combinations of one or more features described herein. Any ranges given herein include any and all specific values within the range and any and all sub-ranges within the given range.

**Claims**

1. A fault monitoring device (2) for a power system (1) that comprises a high side voltage rail (3), a low side voltage rail (4), and a chassis (5) insulated by a high side insulation resistance ($R_{ISOH}$) from the high side voltage rail (3) and insulated by a low side insulation resistance ($R_{ISOL}$) from the low side voltage rail (4), wherein the fault monitoring device (2) comprises:

   a first parallel circuit (21, 22) of resistors (R_MEAS_1, R_MEAS_2, R_INJ_1, R_INJ_2, R_INJ_3), the first parallel circuit comprising a first branch (21) and a second branch (22) both connected at one end thereof to the high side voltage rail (3) of the power system;
   a second parallel circuit (23, 24) of resistors (R_MEAS_3, R_MEAS_4, R_INJ_4, R_INJ_5, R_INJ_6), the second parallel circuit comprising a third branch (23) and a fourth branch (24) both connected at one end thereof to the low side voltage rail (4) of the power system;
   wherein the first branch (21), second branch (22), third branch (23) and fourth branch (24) are each connected at the other end thereof to the chassis (5) of the power system;
   wherein the second branch (22) of the first parallel circuit (21, 22) comprises at least two electrical resistors (R_INJ_1, R_INJ_2, R_INJ_3) arranged in series, wherein at least one of the electrical resistors (R_INJ_2, R_INJ_3) can be short-circuited by a first switch (SW1, SW3);
   wherein the fourth branch (24) of the second parallel circuit (23, 24) comprises at least two electrical resistors (R_INJ_4, R_INJ_5, R_INJ_6) arranged in series, wherein at least one of the electrical resistors (R_INJ_4, R_INJ_5) can be short-circuited by a second switch (SW2, SW4); and
   a controller (6) configured to selectively switch the switches (SW1, SW2, SW3, SW4) of the second branch (22) and of the fourth branch (24) to provide for different states of the first and second parallel circuits (21, 22; 23, 24);
   the controller (6) further configured to determine from voltage changes associated with the different states the resistance values for the high side insulation resistance ($R_{ISOH}$) and for the low side insulation resistance ($R_{ISOL}$) of the power system.

2. The fault monitoring device of claim 1, wherein the second branch (22) of the first parallel circuit (21, 22) comprises three electrical resistors (R_INJ_1, R_INJ_2, R_INJ_3) arranged in series, wherein two of the electrical resistors (R_INJ_2, R_INJ_3) can be short-circuited by the first switch (SW1) and a third switch (SW3), respectively.

3. The fault monitoring device of claim 2, wherein the fourth branch (24) of the second parallel circuit (23, 24) comprises three electrical resistors (R_INJ_4, R_INJ_5, R_INJ_6) arranged in series, wherein two of the electrical resistors (R_INJ_4, R_INJ_5) can be short-circuited by the second switch (SW2) and a fourth switch (SW4), respectively.

4. The fault monitoring device of any preceding claim, wherein the controller (6) is configured to define two different states by the selective switching, wherein the controller (6) determines from the voltage changes associated with the two different states the resistance values for the high side insulation resistance ($R_{ISOH}$) and the low side insulation resistance ($R_{ISOL}$).

5. The fault monitoring device of claim 4, wherein the controller (6) is configured to determine from the voltage changes associated with the two different states the resistance values for the high side insulation resistance ($R_{ISOH}$) and the low side insulation resistance ($R_{ISOL}$) in that it is configured to:

   measure:

   a high side voltage ($U_{HIGH}$) between the high side voltage rail (3) and the chassis (5),
   a low side voltage ($U_{LOW}$) between the chassis (5) and the low side voltage rail (4), and
   the high side voltage ($U_{HIGH1}$, $U_{HIGH2}$) and the low side voltage ($U_{LOW1}$, $U_{LOW2}$) in the two different states; and

   use the high side voltages ($U_{HIGH1}$, $U_{HIGH2}$) of the two different states, the low side voltages ($U_{LOW1}$, $U_{LOW2}$) of the two different states, and the change of resistance of the sum of the resistors (R_INJ_1, R_INJ_2, R_INJ_3) of the second branch (22) and/or of the sum of the resistors (R_INJ_4, R_INJ_5, R_INJ_6) of the fourth branch (24) between the two different states to calculate the high side insulation resistance ($R_{ISOH}$) and the low side insulation resistance ($R_{ISOL}$).

6. The fault monitoring device of claim 4 or 5, wherein the first state is defined in that one of the electrical resistors (R_INJ_2, R_INJ_3) of the second branch is short-circuited while none of the electrical resistors (R_INJ_4, R_INJ_5) of the fourth branch (24) is short-circuited, and in that the second state is defined in that none of the electrical resistors (R_INJ_2, R_INJ_3) of the second branch is short-circuited while one of the electrical resistors (R_INJ_4, R_INJ_5) of the fourth branch (24) is short-circuited.

7. The fault monitoring device of claim 6, when dependent on claim 3, wherein in the first state one of the electrical resistors (R_INJ_2) of the second branch is short-circuited by the first switch (SW1) and in the second state one of the electrical resistors (R_INJ_4) of the fourth branch is short-circuited by the second switch (SW2).

8. The fault monitoring device of claim 6, when dependent on claim 3, wherein in the first state one of the electrical resistors (R_INJ_3) of the second branch is short-circuited by the third switch (SW3) and in the second state one of the electrical resistors (R_INJ_5) of the fourth branch is short-circuited by the fourth switch (SW4).

9. The fault monitoring device of any one of claims 6 to 8, wherein the high side insulation resistance ($R_{ISOH}$) and the low side insulation resistance ($R_{ISOL}$) are calculated by the formulae:

$$R_{ISO_H} = \frac{\dfrac{U_{HIGH_1}}{U_{LOW_1}} - \dfrac{U_{HIGH_2}}{U_{LOW_2}}}{-\dfrac{U_{HIGH_1}}{U_{LOW_1}}\dfrac{1}{R_{MEAS}} - \dfrac{U_{HIGH_1}}{U_{LOW_1}}\dfrac{1}{R_{INJ_{ON}}} + \dfrac{U_{HIGH_2}}{U_{LOW_2}}\dfrac{1}{R_{MEAS}} + \dfrac{U_{HIGH_2}}{U_{LOW_2}}\dfrac{1}{R_{INJ_{OFF}}} + \dfrac{1}{R_{INJ_{OFF}}} - \dfrac{1}{R_{INJ_{ON}}}}$$

$$R_{ISO_L} =$$

$$= \frac{\dfrac{U_{HIGH_1}}{U_{LOW_1}} - \dfrac{U_{HIGH_2}}{U_{LOW_2}}}{\dfrac{U_{HIGH_1}}{U_{LOW_1}}\dfrac{U_{HIGH_2}}{U_{LOW_2}}\dfrac{1}{R_{INJ_{OFF}}} - \dfrac{U_{HIGH_1}}{U_{LOW_1}}\dfrac{U_{HIGH_2}}{U_{LOW_2}}\dfrac{1}{R_{INJ_{ON}}} - \dfrac{U_{HIGH_1}}{U_{LOW_1}}\dfrac{1}{R_{MEAS}} - \dfrac{U_{HIGH_1}}{U_{LOW_1}}\dfrac{1}{R_{INJ_{ON}}} + \dfrac{U_{HIGH_2}}{U_{LOW_2}}\dfrac{1}{R_{MEAS}} + \dfrac{U_{HIGH_2}}{U_{LOW_2}}\dfrac{1}{R_{INJ_{OFF}}}}$$

wherein:

$R_{ISOH}$ is the high side insulation resistance;
$R_{ISOL}$ is the low side insulation resistance;
$U_{HIGH1}$ is high side voltage between the high side voltage rail (3) and the chassis (5) in the first state;
$U_{HIGH2}$ is the high side voltage between the high side voltage rail (3) and the chassis (5) in the second state;
$U_{LOW1}$ is the low side voltage between the chassis (5) and the low side voltage rail (4) in the first state;
$U_{LOW2}$ is the low side voltage between the chassis (5) and the low side voltage rail (4) in the second state;
$R_{MEAS}$ is the resistance of the first branch and the resistance of the third branch;
$R_{INJON}$ is the resistance of the sum of the resistors of the second branch and the sum of the resistors of the fourth branch if one of the resistors of the respective branch is short-circuited; and
$R_{INJOFF}$ is the resistance of the sum of the resistors of the second branch and the sum of the resistors of the fourth branch if none of the resistors are short-circuited.

10. The fault monitoring device of claim 5 or any one of claims 6 to 9 when dependent on claim 5, wherein:

the first branch (21) comprises a first voltage divider (R_MEAS_1, R_MEAS_2), wherein the fault monitoring device is configured to measure the high side voltage ($U_{HIGH}$) between the high side voltage rail (3) and the chassis (5) by means of the first voltage divider; and
the third branch (23) comprises a second voltage divider (R_MEAS_3, R_MEAS 4), wherein the fault monitoring device is configured to measure the low side voltage ($U_{LOW}$) between the chassis (5) and the low side voltage rail (4) by means of the second voltage divider.

11. The fault monitoring device of any preceding claim, wherein the voltage changes associated with the different states settle with an exponential curve due to capacitances ($C_{ISOH}$, $C_{ISOL}$) that are connected in parallel to the high side insulation resistance ($R_{ISOH}$) and the low side insulation resistance ($R_{ISOL}$), wherein the controller (6) is configured to apply a regression analysis which estimates the voltage changes before they are settled in.

12. The fault monitoring device of claim 11, wherein the controller (6) is configured to apply as regression analysis for the voltage of each of the capacitances ($C_{ISOH}$, $C_{ISOL}$):

measuring (41) voltage values at the beginning only of an exponential charging curve (9) charging the capacitance ($C_{ISOH}$, $C_{ISOL}$);

calculating (42) the derivatives of the measured voltage values and subsequently a logarithm of the derivatives;

fitting (43) a line (10) through the calculated values using a linear regression method, the line (10) being defined by parameters (m, b); and

using (44) the initial voltage value (U1) of the capacitance ($C_{ISOH}$, $C_{ISOL}$) and the line parameters (m, b) to calculate the end voltage (U2).

13. The fault monitoring device of claim 12, wherein the line (10) comprises as parameters a slope (m) and a y-intercept (b), wherein the controller (6) is configured to implement the using step in that the using step comprises using the initial voltage value (U1) of the capacitance ($C_{ISOH}$, $C_{ISOL}$), the slope (b) and the y-intercept (b) to calculate the end voltage (U2).

14. The fault monitoring device of claim 13, wherein, when $\tau$ is the time constant of the capacitance, voltage values of the exponential charging curve (9) are measured up to at most $\tau$, in particular up to at most $\tau/2$.

15. A power system comprising:

a DC battery (7) having a DC battery positive terminal (71), a DC battery negative terminal (72) and a battery voltage ($U_B$);

a high side voltage rail (3) connected to the DC battery positive terminal (71);

a low side voltage rail (4) connected to the DC battery negative terminal (72);

a chassis (5);

a high side insulation resistance ($R_{ISOH}$) insulating the chassis (5) from the high side voltage rail (3);

a low side insulation resistance ($R_{ISOL}$) insulating the chassis (5) from the low side voltage rail (4); and

a fault monitoring device in accordance with any preceding claim.

Fig. 1

Fig. 2

Fig. 3

```
┌─────────────────────────────────────────────────────┐
│    measuring voltage values at the beginning only of an │ ⌐41
│  exponential charging curve charging a the capacitance  │
└─────────────────────────────────────────────────────┘
                          │
                          ▼
┌─────────────────────────────────────────────────────┐
│   calculating the derivatives of the measured voltage values │ ⌐42
│      and subsequently a logarithm of the derivatives     │
└─────────────────────────────────────────────────────┘
                          │
                          ▼
┌─────────────────────────────────────────────────────┐
│    fitting a line through the calculated values using a linear │ ⌐43
│  regression method, the line being defined by parameters m, b │
└─────────────────────────────────────────────────────┘
                          │
                          ▼
┌─────────────────────────────────────────────────────┐
│    using the initial voltage value of the capacitance and the │ ⌐44
│       line parameters m, b to calculate the end voltage  │
└─────────────────────────────────────────────────────┘
```

Fig. 4

Europäisches
Patentamt

European
Patent Office

Office européen
des brevets

# EUROPEAN SEARCH REPORT

Application Number

EP 24 16 3725

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 660 520 A1 (MUNICH ELECTRIFICATION GMBH [DE]) 3 June 2020 (2020-06-03) * paragraphs [0001] - [0010], [0040] - [0048], [0057] - [0076], [0081] - [0083]; figures 2-4 * | 1-15 | INV. G01R27/02 G01R27/20 G01R31/52 |
| X | US 2022/252657 A1 (GUO HAIBIN [CN] ET AL) 11 August 2022 (2022-08-11) | 1,4,6,15 | |
| A | * paragraphs [0066] - [0070]; figure 1 * | 2,3,5, 7-14 | |

TECHNICAL FIELDS
SEARCHED       (IPC)

G01R

The present search report has been drawn up for all claims

| Place of search | Date of completion of the search | Examiner |
|---|---|---|
| Munich | 16 August 2024 | Jedlicska, István |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 16 3725

This annex lists the patent family members relating to the patent documents cited in the above-mentioned European search report.
The members are as contained in the European Patent Office EDP file on
The European Patent Office is in no way liable for these particulars which are merely given for the purpose of information.

16-08-2024

| Patent document cited in search report | | Publication date | Patent family member(s) | | Publication date |
|---|---|---|---|---|---|
| EP 3660520 | A1 | 03-06-2020 | NONE | | |
| US 2022252657 | A1 | 11-08-2022 | CN | 114910699 A | 16-08-2022 |
| | | | US | 2022252657 A1 | 11-08-2022 |

EPO FORM P0459

For more details about this annex : see Official Journal of the European Patent Office, No. 12/82

**EP 4 439 093 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20220413034 A1

- US 20220413035 A1